# EUROPÄISCHE PATENTSCHRIFT

(11) **EP 3 341 973 B1**
(45) Veröffentlichungstag und Bekanntmachung des Hinweises auf die Patenterteilung: **22.02.2023**
(21) Anmeldenummer: 16756711.4
(22) Anmeldetag: 25.08.2016
(51) Int. Cl.: H01L 31/18

(54) **VERFAHREN ZUM STABILISIEREN EINER PHOTOVOLTAISCHEN SILIZIUM-SOLARZELLE**
METHOD FOR STABILISING A PHOTOVOLTAIC SILICON SOLAR CELL
PROCÉDÉ POUR STABILISER UNE CELLULE SOLAIRE PHOTOVOLTAÏQUE AU SILICIUM

(30) Priorität: 27.08.2015 DE 102015114298
(43) Veröffentlichungstag der Anmeldung: 04.07.2018
(73) Patentinhaber: Fraunhofer-Gesellschaft zur Förderung der angewandten Forschung e.V., 80686 München (DE)
(72) Erfinder: NEKARDA, Jan, 79194 Gundelfingen (DE); BRAND, Andreas, 79106 Freiburg (DE); REIN, Stefan, 79211 Denzlingen (DE); FERTIG, Fabian, 10827 Berlin (DE); KRAUSS, Karin, 79115 Freiburg (DE)
(74) Vertreter: LBP Lemcke, Brommer & Partner Patentanwälte mbB
(86) Internationale Anmeldenummer: PCT/EP2016/070039
(87) Internationale Veröffentlichungsnummer: WO 2017/032820

(56) Entgegenhaltungen:
- WO-A1-2014/206504
- DE-A1-102009 059 300
- GEORG KRUGEL ET AL: "Impact of Hydrogen Concentration on the Regeneration of Light Induced Degradation", ENERGY PROCEDIA, Bd. 8, 17. April 2011 (2011-04-17), - 20. April 2011 (2011-04-20), Seiten 47-51, XP028263042, ISSN: 1876-6102, DOI: 10.1016/J.EGYPRO.2011.06.100 [gefunden am 2011-08-12]

## Beschreibung

Die Erfindung betrifft ein Verfahren zum Stabilisieren einer photovoltaischen Siliziumsolarzelle gemäß Oberbegriff des Anspruchs 1.

Photovoltaische Silizium-Solarzellen dienen zur Umwandlung der Energie einfallender Strahlung in elektrische Energie. Ein maßgeblicher Parameter für die Wirtschaftlichkeit solcher Solarzellen ist insbesondere der Wirkungsgrad, welcher erheblich von der Materialgüte und somit insbesondere von einer Rekombinationsaktivität hinsichtlich der generierten Ladungsträger abhängig ist. Weiterhin stellen die Materialkosten einen erheblichen Anteil an den Gesamtkosten typischer Silizium-Solarzellen dar, so dass ein Bedarf an kostengünstigen Materialien, die dennoch eine hohe Güte und insbesondere hohe Ladungsträgerlebensdauern ermöglichen. Insbesondere bei Solarzellen basierend auf kristallinen Siliziumsubstraten werden jedoch Degradationseffekte festgestellt, d. h. die Güte des verwendeten Materials verringert sich bei Benutzung der Solarzelle.

Es besteht daher ein Bedarf an Verfahren, welche solche Solarzellen in einem regenerierten Zustand mit einer hohen Güte stabilisieren, so dass keine oder nur eine deutlich verringerte Degradation bei Benutzung erfolgt. Da auch die Kosten des Herstellungsverfahrens und somit insbesondere die benötigte Prozesszeit signifikant in die Gesamtkosten einfließen besteht weiterhin der Bedarf, solche Verfahren zu beschleunigen.

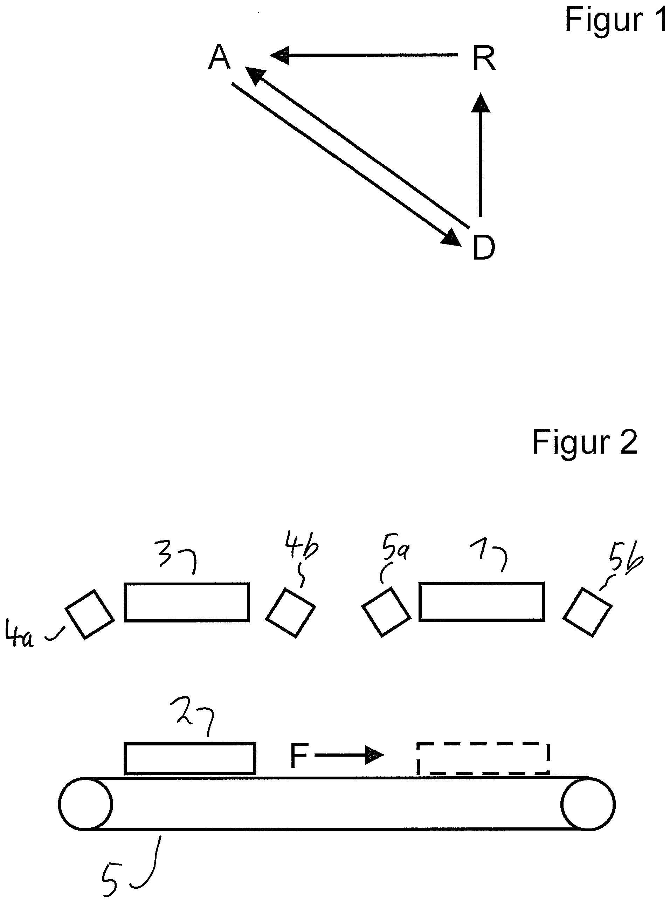

In besonders starkem Maße wurde ein Degradationsverhalten wie zuvor beschrieben in Verbindung mit Bor-Sauerstoff basierten Defekten im Halbleitersubstrat der Silizium-Solarzelle. Durch Temperaturbehandlung und typischerweise einer Passivierung mittels Wasserstoff konnten Verfahren gezeigt werden, welche eine Stabilisierung solcher Solarzellen ermöglichen:
Ein Erklärungsmodell ist hierbei das in Figur 1 gezeigte -Zustandsmodell. Hierbei geht man von einem getemperten ("annealed") Zustand A aus, in welchem die Solarzelle zwar eine hohe Güte besitzt, jedoch bei Benutzung aufgrund der Beaufschlagung mit Strahlung, typischerweise Sonnenlicht, degradiert. In einem degradierten Zustand D ist die Solarzelle zwar stabil, weist jedoch einen deutlich verringerten Wirkungsgrad auf. Ziel ist es, einen regenerierten Zustand R zu erzielen, der unter typischen Benutzungsbedingungen stabil ist und gegenüber dem Zustand D einen verbesserten Wirkungsgrad aufweist.

Nach aktueller Kenntnis sind die Zustände annealed und degradiert reversibel. Aus einem regenerierten Zustand kann unter ungünstigen Bedingungen ein Übergang in den annealed-Zustand erfolgen, nicht jedoch ein direkter Übergang in den degradierten Zustand. Weiterhin ist in Figur 1 anhand der Pfeile kenntlich gemacht, dass aus einem annealed-Zustand kein direkter Übergang in einen regenerierten Zustand möglich ist, sondern ein Weg über einen degradierten Zustand gewählt werden muss.

Diese Effekte wurden insbesondere bei der Verwendung von Czochralski (Cz)-Silizium beobachtet. Ebenso scheinen solche oder vergleichbare Effekte auch bei multikristallinen Siliziumwafern aufzutreten.

Verfahren zum Stabilisieren einer photovoltaischen Silizium-Solarzelle wie zuvor beschrieben sind aus WO 2014/206504 A1, EP 1 997 157 B1 und EP 2 164 114 B1 bekannt. Das Dokument DE 10 2009 059300 A1 offenbart ein Verfahren zum Stabilisieren einer photovoltaischen Silizium-Solarzelle, mit einem Regenerationsschritt, wobei ein Injizieren von Ladungsträgern in einem Halbleitersubstrat der auf zumindest 50°C erwärmten Solarzelle erfolgt. Vor dem Regenerationsschritt erfolgt ein Degradationsschritt, wobei die Solarzelle mittels Strahlung beaufschlagt wird.

Der vorliegenden Erfindung liegt die Aufgabe zugrunde, ein Verfahren zum Stabilisieren einer photovoltaischen Silizium-Solarzelle bereitzustellen, um ein weniger fehleranfälliges und/oder beschleunigtes Stabilisieren der Silizium-Solarzelle zu ermöglichen.

Gelöst ist diese Aufgabe durch ein Verfahren gemäß Anspruch 1. Vorteilhafte Ausgestaltungen des erfindungsgemäßen Verfahrens finden sich in den abhängigen Unteransprüchen.

Das erfindungsgemäße Verfahren zum Stabilisieren einer photovoltaischen Silizium-Solarzelle weist einen Regenerationsschritt auf, wobei ein Injizieren von Ladungsträgern in einem Halbleitersubstrat der auf zumindest 50 °C erwärmten Solarzelle erfolgt. Ein derartiger Regenerationsschritt ist aus dem Stand der Technik bekannt.

Die Erfindung basiert insbesondere auf der Erkenntnis, dass das Maß der Degradation der Solarzelle vor Regeneration einen erheblichen Anteil an der Zuverlässigkeit und der Gesamtdauer des Stabilisierungsprozesses aufweist. Einer vorgelagerten Degradation vor einer Regeneration kommt somit eine zweifache Bedeutung zu: Einerseits ist für die Gesamtqualität des Stabilisierungsprozesses entscheidend, dass vor dem Regenerationsschritt das betroffene Material möglichst keine oder nur vernachlässigbar geringe Anteile im annealed-Zustand aufweist. Denn wie zuvor ausgeführt, ist ein direkter Übergang aus dem annealed-Zustand in den regenerierten Zustand nicht möglich. Darüber hinaus stellt jedoch der Prozess der Degradation einen ebenso oder sogar stärker zeitaufwändigen Prozess verglichen mit dem Prozess der Regeneration dar. Die vorliegende Erfindung basiert somit auf der Erkenntnis, dass ein Verfahren zum Stabilisieren einer photovoltaischen Silizium-Solarzelle durch eine Erhöhung der Fehlerunanfälligkeit und/oder eine Verringerung der Prozessdauer des Degradationsschrittes erheblich verbessert werden kann. Diesbezüglich basiert die Erfindung weiterhin auf der Erkenntnis, dass eine besonders vorteilhafte Verbesserung des Degradationsschrittes erzielt wird, indem eine hohe Generationsrate von Ladungsträgern in der Solarzelle mittels Bestrahlung erzielt wird und gleichzeitig eine zu hohe Temperatur der Solarzelle vermieden wird.

Das erfindungsgemäße Verfahren weist daher einen Degradationsschritt auf, welcher vor dem Regenerationsschritt erfolgt, wobei die Solarzelle mittels Laserstrahlung mit einer Bestrahlungsintensität von zumindest 5.000 W/m² (5 kW/m²) beaufschlagt und gleichzeitig die Solarzelle aktiv gekühlt wird.

Insbesondere die Kombination des Erzeugens einer stark erhöhten Ladungsträgerdichte freier Ladungsträger aufgrund der Beaufschlagung der Solarzelle mit der vorgenannten hohen Bestrahlungsintensität mit dem aktiven Kühlen ermöglicht somit einen einerseits vergleichsweise schnellen Degradationsschritt, der zusätzlich eine weitgehende oder nahezu vollständige Überführung der Materialbereiche der Solarzelle im annealed-Zustand in den degradierten Zustand sicherstellt. Die aktive Kühlung bietet hier zweierlei Vorteile: Einerseits wird vermieden, dass aufgrund der hohen Bestrahlungsintensität eine starke Erwärmung der Solarzelle erfolgt. Darüber hinaus gehen bei typischen Herstellungsprozessen einer photovoltaischen Silizium-Solarzelle dem Stabilisierungsschritt Prozessierungsschritte voraus, welche eine Temperatureinwirkung und damit Erwärmung der Solarzelle mit sich führen. Die aktive Kühlung führt somit darüber hinaus zu einer Verfahrensbeschleunigung, indem für den Degradationsschritt die Solarzelle auch bei einer vorangehenden Erwärmung im Herstellungsverfahren durch die aktive Kühlung schnell in den Zustand einer verringerten Temperatur gebracht werden kann.

Das erfindungsgemäße Verfahren ermöglicht somit einerseits aufgrund der hohen Bestrahlungsintensität, bei welcher gleichzeitig aufgrund der aktiven Kühlung eine zu starke Erwärmung vermieden wird, eine hohe Güte im Sinne einer vollständigen oder zumindest nahezu vollständigen Eliminierung von Materialbereichen im annealed-Zustand und eine erhebliche Verfahrensbeschleunigung und damit auch Kostensenkung im Stabilisierungsprozess.

Eine zu starke Erwärmung der Solarzelle weist den Nachteil auf, dass eine negative Beeinträchtigung der Solarzelle bis hin zu einer Beschädigung erfolgen kann, insbesondere metallische Kontaktierungsstrukturen und deren elektrische und mechanische Verbindung zu Halbleiterschichten können beeinträchtigt werden, ebenso die elektronische Güte der Halbleitermaterialien, insbesondere die Minoritätsladungsträgerlebensdauer oder die elektrische Passivierungsgüte von Oberflächen der Halbleiterschichten. Weiterhin ist es vorteilhaft, den Degradations-Zustand möglichst durch reine Erwärmung und gleichzeitig mit einer nicht stark erhöhten freien Ladungsträgerdichte zu erzielen. Durch eine exakte Vorgabe der Temperatur, auf welche sich die Solarzelle erwärmt, zumindest das Einhalten einer Temperaturobergrenze wird eine unvorteilhaft hohe Ladungsträgerdichte vermieden.

Aufgrund der aktiven Kühlung, welche die Nachteile einer zu starken Erwärmung vermeidet eröffnet darüber hinaus die Möglichkeit der Verwendung sehr hoher Bestrahlungsintensitäten für die Degradation der Solarzelle. Es ist daher vorteilhaft, in dem Degradationsschritt die Solarzelle mittels Laserstrahlung mit einer Bestrahlungsintensität von zumindest 10.000 W/m², insbesondere zumindest 50.000 W/m², bevorzugt zumindest 100.000 W/m², insbesondere bevorzugt zumindest 500.000 W/m² zu beaufschlagen und gleichzeitig die Solarzelle aktiv zu kühlen.

Solche hohen Lichtintensitäten über einen vergleichsweise kurzen Zeitraum können insbesondere vorteilhaft durch die Verwendung von Lasern erzeugt werden. Laser weisen den Vorteil auf, dass eine apparativ vergleichsweise geringe Wärmeentwicklung verglichen mit anderen Strahlungsquellen wie beispielsweise Xenon- oder Halogenlampen erfolgt und darüber hinaus über eine große Anzahl von Zyklen ein schnelles An- und Abschalten der Laserstrahlung möglich ist. Insbesondere geeignet sind hierfür Diodenlaser.

Die vorgenannten vorteilhaften Effekte werden in besonderer Weise erzielt und die nachteiligen Effekte eine zu starken Erwärmung vermieden, indem in einer bevorzugten Ausführungsform in dem Degradationsschritt die Solarzelle eine Temperaturobergrenze von 100 °C, insbesondere von 70 °C, bevorzugt von 60 °C, insbesondere bevorzugt von 50 °C, weiter bevorzugt von 40 °C nicht überschreitet, insbesondere bevorzugt unterstützt durch eine aktive Kühlung der Solarzelle, bevorzugt während des Degradationsschrittes.

Eine zu hohe Temperatur birgt insbesondere die Gefahr, dass die Bildungsrate für den annealed-Zustand dominant gegenüber den anderen Prozessen ist. Daher wird vorteilhafterweise eine zu hohe Temperatur, insbesondere größer 100°C vermieden.

Bereits bei einer Temperatur kleiner 100 °C ist eine erhebliche Verbesserung zu erwarten, da bei solch einer Temperatur keine oder nur geringfügig eine Regeneration erfolgt und somit ausgeschlossen wird, dass ein degenerierter Bereich regeneriert wird und anschließend in den annealed-Zustand gerät.

Weiterhin ist die Kombination einer hohen Bestrahlungsintensität mit einer verringerten Temperatur vorteilhaft für eine dominante Degradation. Bei typischen Materialien, insbesondere bei Cz-Silizium ist es daher besonders vorteilhaft, eine Temperatur kleiner 70 °C, weiter bevorzugt kleiner 60 °C zu wählen. Insbesondere bei Temperaturen kleiner 50 °C und weiter bevorzugt kleiner 40 °C für einen dominanten Degenerationsprozess.

Um eine zu hohe Temperatur zu vermeiden ist es vorteilhaft, dass die Temperatur der Solarzelle gemessen wird, vorzugsweise mittels einer optischen Temperaturmessung, und dass die Bestrahlungsintensität und/oder eine aktive Kühlung derart gewählt wird, dass die Temperatur der Solarzelle in eine vorgegebene Maximaltemperatur nicht übersteigt, insbesondere in einem vorgegebenen Temperaturbereich liegt.

Eine Regelung der Solarzellentemperatur durch Temperaturmessung der Temperatur der Solarzelle und abhängig von der gemessenen Temperatur Ändern der Bestrahlungsstärke und/oder der Kühlleistung, mit welcher die Solarzelle gekühlt wird, ermöglicht ein sicheres Vermeiden zu hoher Temperaturen. Insbesondere die Verwendung kontaktloser, bevorzugt optischer Temperaturmessungen ist hierbei vorteilhaft, um zusätzliche Fehlerquellen auszuschließen. Weiterhin ist hierbei insbesondere die Verwendung von monochromatischer Strahlung im sichtbaren Spektrum, bevorzugt Laserstrahlung, vorteilhaft, da hierdurch keine Beeinflussung einer optischen Temperaturmessung im Wärmespektrum erfolgt. Weiterhin ist hierbei insbesondere die Verwendung von Lasern zum Erzeugen der Strahlung vorteilhaft, da die Leistung von Lasern gegenüber anderen Lichtquellen sehr schnell und exakt gesteuert werden kann und somit eine sehr schnelle und genaue Regelung der Temperatur der Solarzelle möglich ist.

Die Kombination der Degradierung durch Bestrahlung mit hoher Intensität bei gleichzeitig aktiver Kühlung ermöglicht wie zuvor beschrieben eine vorteilhaft kurze Zeitdauer des Degradationsschrittes. Vorteilhafterweise wird daher der Degradationsschritt für eine Zeitdauer im Bereich 0,1 s bis 20 s, vorzugsweise im Bereich 0,1 s bis 5 s durchgeführt. Hierdurch ergeben sich insbesondere Kosteneinsparungen aufgrund der verringerten Gesamtdauer des Stabilisierungsprozesses.

Das Beaufschlagen der Solarzelle mittels Strahlung mit einer hohen Strahlungsintensität von zumindest 5.000 W/m² bewirkt eine hohe Generationsrate von Elektron-Lochpaaren in der Silizium-Solarzelle. Hierbei liegt die Verwendung von breitbandiger Strahlung im Rahmen der Erfindung, insbesondere die Verwendung breitbandiger Lichtquellen wie beispielsweise Halogen- oder Xenonlampen. Ebenso liegt es im Rahmen der Erfindung, dass die Strahlung eine monochromatische Strahlung ist. Dies ist insbesondere von Vorteil, da mittels monochromatischer Strahlung eine hohe Generation von Elektron-Lochpaaren bei vergleichsweise geringer Erwärmung erzielt werden kann. Daher ist insbesondere die Verwendung von Lasern vorteilhaft. Für eine hohe Effizienz hinsichtlich der Generation von Elektron-Lochpaaren in der Silizium-Solarzelle ist die Verwendung von Strahlung mit Spektrum, welches eine hohe Absorption im Halbleitersubstrat der Solarzelle aufweist, vorteilhaft. Insbesondere liegt vorteilhafterweise das Spektrum der im Degradationsschritt verwendeten Strahlung im Wellenlängenbereich 300 nm bis 1.200 nm, bevorzugt 600 nm bis 1.000 nm. Besonders vorteilhaft ist für ein gegebenes Halbleitermaterial somit ein Spektrum, welches oberhalb und nahe der Bandkante des Halbleitermaterials liegt. Hierdurch ist eine effiziente Generation von Elektron-Lochpaaren bei minimierter Erwärmung gegeben.

Untersuchungen zeigten weiterhin, dass eine deutliche Beschleunigung auch des Regenerationsprozesses durch hohe Strahlungsintensitäten möglich ist. Bisher bestand das wissenschaftliche Vorurteil, dass ab einer Beleuchtungsstärke von etwa 1.000 W/m² (1 kW/m²) keine weitere Beschleunigung des Regenerationsprozesses mit steigender Beleuchtungsintensität auftritt. Die Untersuchungen ergaben jedoch, dass bei erheblich höheren Intensitäten in den entsprechenden Temperaturregimen eine vorteilhaft kurze Gesamtprozessdauer erzielt werden kann:
In einer vorteilhaften Ausführungsform erfolgt der Regenerationsschritt bei aktiver Kühlung der Solarzelle auf eine Temperatur kleiner 250 °C, bevorzugt kleiner 230 °C und Beaufschlagen der Solarzelle mit einer Strahlungsintensität von zumindest 10.000 W/m² (10 kW/m²). Hierdurch lassen sich vorteilhaft kurze Gesamtprozessdauern erzielen. Insbesondere ist es vorteilhaft, dass bei den vorgenannten Parametern die Gesamtprozessdauer von Degradationsschritt und Regenerationsschritt weniger als 50 s beträgt. Besonders vorteilhaft hierbei ist es, während des Regenerationsschrittes die Solarzelle auf eine Temperatur im Bereich 150 °C bis 250 °C, insbesondere 200 °C bis 250 °C zu kühlen.

Die Untersuchungen zeigten jedoch weiterhin, dass weit höhere Beleuchtungsstärken von Vorteil sind, um eine Regeneration mit einer hohen Güte zu erzielen und dass bei diesen Beleuchtungsstärken erheblich höhere Temperaturen nicht nachteilig sind, die Solarzelle jedoch eine Maximaltemperatur von 400 °C nicht überschreiten sollte. In einer vorteilhaften Ausgestaltung erfolgt daher während des Regenerationsschrittes eine aktive Kühlung der Solarzelle auf eine Temperatur im Bereich 250 °C bis 400 °C, insbesondere 300°C bis 400°C und die Solarzelle wird mit einer Strahlungsintensität von zumindest 10.000 W/m², vorzugsweise zumindest 50.000 W/m², insbesondere zumindest 70.000 W/m² beaufschlagt. Hierdurch kann eine hohe Regenerationsqualität bei kurzer Gesamtprozessdauer erzielt werden. Vorteilhafterweise beträgt bei den vorgenannten Parametern die Gesamtprozessdauer von Degradationsschritt und Regenerationsschritt weniger als 50 s.

Die Vorteile der vorliegenden Erfindung liegen insbesondere in einer weitgehend oder bevorzugt vollständigen Degradation von annealed-Zuständen der Solarzelle bei kurzer Prozessdauer des Degradationsschrittes. Es ist daher insbesondere vorteilhaft, negative Einflüsse auf den Degradationsprozess, welche aus einem Regenerationsprozess folgen können, zu vermeiden. Vorteilhafterweise wird daher der Regenerationsschritt nach Abschluss des Degradationsschrittes durchgeführt. Es handelt sich somit um zwei separate, zeitlich hintereinander folgende Prozessschritte, d.h. in einem ersten Prozessschritt ist die Degradation dominant und in einem zweiten, späteren Prozessschritt ist die Regeneration dominant. Hierbei liegt es im Rahmen der Erfindung, zwischen Degradationsschritt und Regenerationsschritt einen oder mehrere Zwischenschritte zwischenzuschalten. Vorzugsweise erfolgt jedoch zur Vermeidung von Störungen, welche zu einer Rückkehr in annealed-Zustände führen können, unmittelbar nach Abschluss des Degradationsschrittes der Regenerationsschritt.

Es liegt hierbei im Rahmen der Erfindung, dass Degradation und Regeneration lediglich in einem oder mehreren Teilbereichen der Solarzelle durchgeführt werden. Hierbei ist es vorteilhaft, dass sukzessive eine Degradation und Regeneration in einer Mehrzahl von Teilbereichen erfolgt, so dass die Gesamtheit der Teilbereiche die Silizium-Solarzelle im Wesentlichen oder bevorzugt vollständig überdeckt. Insbesondere ist ein hinsichtlich der konstruktiven Anforderungen an die verwendete Vorrichtung Ausführungsform des Verfahrens vorteilhaft, bei welcher in einem streifenartigen Bereich, welcher bevorzugt eine Breite der Solarzelle vollständig überdeckt, zunächst an einem ersten Bereich eine Degradation und an einem nachfolgenden Bereich eine Regeneration erfolgt, wobei der streifenartige Bereich relativ zu der Solarzelle bewegt wird. Hierdurch kann somit ein vorteilhaftes Durchlaufverfahren realisiert werden, bei welchem beispielsweise die Solarzelle unter einem ersten Bereich, in welchem eine Bestrahlung mit einer Intensität wie zuvor beschrieben bei gleichzeitig aktiver Kühlung zur Ausbildung des Degradationsschrittes erfolgt und in einem nachfolgenden Bereich bei einer höheren Temperatur und vorteilhafterweise einer Beaufschlagung mit Strahlung eine Regeneration erfolgt.

Es ist daher vorteilhaft, dass der Degradationsbereich relativ zu der Solarzelle bewegt wird und/oder dass die Solarzelle sukzessive in mehreren, ortsverschiedenen Degradationsbereichen bestrahlt wird, d.h. mit Degradationsstrahlung beaufschlagt wird.

Insbesondere ist es vorteilhaft, dass ein einem Anfangsbereich, in welchem der Degradationsbereich einen ersten Rand der Solarzelle überdeckt, die Bestrahlung mit einer Anfangsintensität erfolgt und dass in einem Endbereich, in welchem der Degradationsbereich nach der Bestrahlung des Anfangsbereiches einen zweiten Rand, insbesondere einen den ersten Rand gegenüberliegenden Rand der Solarzelle überdeckt, die Bestrahlung mit einer gegenüber der Anfangsintensität geringeren Endintensität erfolgt. Weiter bevorzugt erfolgt in einem Mittelbereich, in welchem der Degradationsbereich nach der Bestrahlung des Anfangsbereiches und vor der Bestrahlung des Endbereiches einen Mittelbereich der Solarzelle überdeckt, eine Bestrahlung in vorteilhafterweise mit einer Mittelintensität, welche kleiner als die Anfangsintensität und größer als die Endintensität ist.

Dies ist darin begründet, dass aufgrund der thermischen Masse der Solarzelle und gegebenenfalls weiterer, thermisch mit der Solarzelle verbundener Elemente bei der Bestrahlung lediglich eines Teilbereiches der Solarzelle zunächst eine Erwärmung auf die gewünschte Temperatur in beschleunigter Form mit einem höheren Energieeintrag und entsprechend einer höheren Anfangsintensität erzielt werden kann. Nach diesem Vorgang kann eine konstante Intensität insbesondere durch Verwendung einer gegenüber der Anfangsintensität geringeren Mittelintensität, d. h. einem vergleichsweise geringeren Energieeintrag aufrechterhalten werden. Bewegt sich der Degradationsbereich nur einem Endbereich mit einem zweiten Rand, insbesondere einem den ersten Rand gegenüberliegenden Rand der Solarzelle zu, so verringert sich die thermische Masse des noch zu erwärmenden Teilbereiches der Solarzelle, so dass bevorzugt in diesem Endbereich eine nochmals geringere Intensität mit einem entsprechend nochmals geringerem Energieeintrag verwendet wird.

Hierdurch wird eine möglichst homogene, konstante Temperatur über das gesamte Volumen und insbesondere die gesamte Fläche der Solarzelle erzielt und damit die Anforderung an die Genauigkeit der aktiven Kühlung in vorteilhafterweise verringert.

Bei einer durch die aktive Kühlung gewährleisteten konstanten Temperatur kann jedoch auch ein Verfahren des Degradationsbereiches wie zuvor beschrieben ohne eine Änderung der Intensität erfolgen. Dies ist insbesondere in vorteilhafterweise möglich, indem die Solarzelle an eine größere thermische Masse, welche die gewünschte Temperatur mittels aktiver Kühlung aufweist, gekoppelt wird. Beispielsweise ist die Verwendung eines Behandlungsblocks, auf welchem die Solarzelle großflächig zur Ausbildung einer hohen thermischen Kopplung bevorzugt mit einer Rückseite ganzflächig aufliegt, vorteilhaft. In apparativ unaufwändiger Weise kann der vorgenannte Block mittels aktiver Kühlung in einen gewünschten Temperaturbereich gebracht werden.

Sofern die Degradation mit einem Degradationsbereich, welcher sich zumindest über eine Breite der Solarzelle erstreckt, erfolgt, kann der Degradationsbereich zumindest orthogonal zu einer Verschieberichtung des Degradationsbereich eine homogene Bestrahlungsintensität aufweisen. Insbesondere kann der Degradationsbereich vollflächig eine homogene Bestrahlungsintensität aufweisen.

Es ist es vorteilhaft, dass in dem Degradationsschritt die Bestrahlung in einem Degradationsbereich erfolgt, wobei an den Rändern der Solarzelle die Bestrahlung mit einer geringeren Randintensität erfolgt, gegenüber einer Mittelbereichsintensität, mit welcher von den Rändern beabstandete Bereiche bestrahlt werden. Dies ist ebenfalls wie zuvor begründet in der geringeren thermischen Ankopplung der Randbereiche an umgebende Solarzellenbereiche verglichen mit Mittelbereichen der Solarzelle begründet.

In einer weiteren vorteilhaften Ausgestaltung wird die Solarzelle während des Degradationsschrittes vollflächig mit der Degradationsstrahlung beaufschlagt.

Hierdurch ist insbesondere in konstruktiv einfacher Weise eine homogene Degradation gewährleistet.

Typischerweise finden Regenerationsschritte vorteilhaft bei deutlich erhöhten Temperaturen gegenüber der Raumtemperatur statt. Es ist damit insbesondere vorteilhaft, dass die Solarzelle während des Regenerationsschrittes eine höhere Temperatur gegenüber dem Degradationsschritt aufweist, insbesondere vorteilhafterweise eine um zumindest 50 °C, insbesondere bevorzugt um zumindest 100 °C, weiter bevorzugt um zumindest 200 °C höhere Temperatur gegengenüber der Temperatur während des Degradationsschrittes.

In vorteilhafterweise wird wie zuvor beschrieben auch bei dem Regenerationsschritt die Solarzelle mit Strahlung beaufschlagt. Hierbei ist typischerweise wie zuvor beschrieben eine höhere Temperatur der Solarzelle gegenüber dem Degradationsschritt vorteilhaft. Dennoch wird in vorteilhafter Weise auch bei dem Regenerationsschritt die Solarzelle aktiv gekühlt. Dies ist darin begründet, dass eine Beschleunigung des Regenerationsschrittes erzielt werden kann, indem eine Bestrahlung mit hoher Intensität erfolgt. Eine solche Bestrahlung kann jedoch zu einer zu starken, d. h. unerwünscht hohen Erwärmung der Solarzelle führen, so dass durch eine aktive Kühlung während des Regenerationsschrittes auch bei der Regeneration die Verwendung hoher Intensitäten der Strahlung möglich ist. Für eine effiziente Regenerierung wird vorteilhafterweise in dem Regenerationsschritt die Solarzelle auf eine Temperatur im Bereich 200 °C bis 500 °C, insbesondere bevorzugt größer 250 °C bis 500 °C, insbesondere bevorzugt 300 °C bis 500 °C geführt. Insbesondere ist es vorteilhaft, mittels aktiver Kühlung die vorgenannten Temperaturbereiche der Solarzelle in dem Regenerationsschritt zu erzielen.

Zum Erzielen einer geringen Gesamtprozessdauer ist es vorteilhaft, dass der Regenerationsschritt für eine Regenerationssdauer T kleiner 3 s, vorzugsweise kleiner 0,5 s durchgeführt wird. Dies wird insbesondere in vorteilhafter Weise unterstützt, indem eine Beaufschlagung der Solarzelle mit hoher Lichtintensität, vorteilhafterweise größer 10kW/m², insbesondere größer 50kW/m², bevorzugt größer 100kW/m², bei gleichzeitig aktiver Kühlung erfolgt.

Eine beispielhafte Vorrichtung zum Stabilisieren einer photovoltaischen Silizium-Solarzelle weist eine Regenerationsstrahlungsquelle zum Beaufschlagen der Solarzelle mit Regenerationsstrahlung auf. Wesentlich ist, dass die Vorrichtung eine Degradationsstrahlungsquelle zum Beaufschlagen der Solarzelle mit Degradationsstrahlung und eine aktive Kühleinheit zum aktiven Kühlen der Solarzelle aufweist.

Die Degradationsstrahlungsquelle ist ausgebildet, die Solarzelle mit Degradationsstrahlung mit einer Intensität von zumindest 5.000 W/m² zu beaufschlagen. Degradationsstrahlungsquelle und Kühleinheit sind derart angeordnet und zusammenwirkend ausgebildet, dass die Solarzelle gleichzeitig mit der Degradationsstrahlung beaufschlagbar und aktiv kühlbar ist.

Hierdurch ergeben sich die bereits bei dem erfindungsgemäßen Verfahren genannten Vorteile, insbesondere kann ein weitreichendes, vorteilhafterweise vollständiges Überführen der annealed-Zustände in Degradationszustände in verglichen mit vorbekannten Verfahren kürzerer Zeit erfolgen.

Wie zuvor bereits beschrieben, ist die Degradationsstrahlungsquelle vorteilhafterweise als Laserstrahlungsquelle ausgebildet, da mittels eines Lasers in vorteilhafter Weise für eine kurze Zeitdauer hohe Lichtintensitäten erzeugt werden können. Hierbei ist insbesondere die Verwendung von Laserdioden vorteilhaft. Typischerweise wird bei dem Degradationsschritt ein flächiger Bereich ausgeleuchtet, welcher bevorzugt zumindest eine Breite der Solarzelle vollständig überdeckt. Insbesondere ist es vorteilhaft, während des Degradationsschrittes die Solarzelle vollständig mit Strahlung zu beaufschlagen. Es ist daher die Verwendung einer Mehrzahl von Laserdioden, insbesondere einer Mehrzahl von in einer Matrixform angeordneten Laserdioden vorteilhaft, um eine großflächige, homogene Ausleuchtung mit hoher Intensität zu erzielen.

Wie zuvor beschrieben ist eine Messung der Solarzellentemperatur und abhängig hiervon eine Regelung der Strahlungsleistung der Degradationsstrahlungsquelle und/oder der Kühlleistung einer Kühleinheit zum Kühlen der Solarzelle vorteilhaft. Es ist somit insbesondere vorteilhaft, dass die Vorrichtung eine Temperaturmesseinheit zum Messen der Temperatur der Solarzelle aufweist, insbesondere eine optische Temperaturmesseinheit, vorzugsweise, dass die Vorrichtung eine Regelungseinheit aufweist, welche mit der Degradationsstrahlungsquelle und/oder einer Kühleinheit zusammenwirkend ausgebildet ist, um eine Temperatur der Solarzelle in einem vorgegebenen Temperaturbereich zu erzielen.

Eine besonders effiziente Kühlung der Solarzelle wird erzielt, indem in einer vorteilhaften Ausgestaltung der Vorrichtung die Kühleinheit eine aktiv gekühlte Halterung für die Solarzelle aufweist, insbesondere zum flächigen Anordnen einer Seite der Solarzelle an der Halterung. Hierdurch ist ein guter thermischer Kontakt zwischen Solarzelle und Halterung gegeben. Typischerweise weisen Solarzellen ein großes Breiten/Dickenverhältnis auf. Typische Solarzellen weisen Seitenlängen größer 10 cm und Dicken kleiner 500 µm auf. Bei Auflegen solch einer Solarzelle mit einer Seite, vorzugsweise mit der Rückseite der Solarzelle auf solch eine Halterung ist somit eine sehr gute thermische Ankopplung an die Halterung gegeben. Die Halterung weist vorzugsweise eine große thermische Masse auf, insbesondere ist die zumindest teilweise oder bevorzugte vollständige Ausführung der Halterung aus Metall vorteilhaft. Die aktive Kühlung kann beispielsweise mittels Zuführen einer Kühlflüssigkeit zu Kühlleitungen an und/oder in der Halterung erfolgen.

In einer weiteren vorteilhaften Ausführungsbeispiel weist die Kühleinheit zumindest ein aktives Gebläse zum Zuführen von einem Kühlfluid zu der Solarzelle, insbesondere zum Anblasen der Solarzelle mit einem Kühlgas, beispielsweise Luft oder einem gereinigten Gas, beispielsweise Argon. Hierdurch kann in einfacher Weise ein aktives Kühlen der Solarzelle erfolgen, unabhängig von dem verwendeten Halterungs- oder Transportmechanismus für die Solarzelle in der Vorrichtung.

Eine vorteilhaft effiziente aktive Kühlung wird durch Zuleiten einer Kühlflüssigkeit auf eine Oberfläche der Solarzelle erzielt. Hierdurch kann die Flüssigkeit insbesondere vorteilhaft in Tropfenform, besonders bevorzugt in Nebelform auf die Solarzelle aufgebracht werden. In einer vorteilhaften Ausführungsform weist die Kühleinheit somit Zuführmittel zum Zuführen eines Kühlfluids auf zumindest einer Oberfläche der Solarzelle auf, insbesondre bevorzugt Mittel zum Sprühen der Kühlflüssigkeit auf die Solarzelle.

Degradationsstrahlungsquelle und Regenerationsstrahlungsquelle sind vorteilhafterweise als zwei separate Strahlungsquellen ausgebildet. Insbesondere sind Degradations- und Regenerationsstrahlungsquelle vorteilhafterweise derart ausgebildet und in der Vorrichtung angeordnet, dass Degradationsstrahlungsquelle und Regenerationsstrahlungsquelle die Solarzelle an verschiedenen Orten mit Strahlung beaufschlagen.

Hierdurch kann in besonders effizienter Weise erzielt werden, dass zunächst der Degradationsschritt abgeschlossen wird, bevorzugt eine Regeneration erfolgt.

In einer weiteren vorteilhaften Ausführungsbeispiel ist Degradationsstrahlungsquelle und Regenerationsstrahlungsquelle als eine einheitliche Degradations- und Regenerationsstrahlungsquelle ausgebildet. Weiterhin ist die Vorrichtung derart ausgebildet, dass die Degradations- und Regenerationsstrahlungsquelle die Solarzelle in lediglich einem Teilbereich der Solarzellenoberfläche beaufschlagt, welcher Teilbereich vorzugsweise eine gesamte Breite der Solarzelle überdeckt. Hierzu weist die Vorrichtung bevorzugt eine Fördereinrichtung auf, zum Fördern der Solarzelle relativ zu der Degradationsstrahlungsquelle.

In dieser vorteilhaften Ausführungsbeispiel wird somit ein Degradationsbereich relativ zu der Solarzelle bewegt und weiterhin Regeneration und Degradation mittels einer Strahlungsquelle, welche somit sowohl Degradationsstrahlungsquelle, als auch Regenerationsstrahlungsquelle ist, erzielt.

Vorteilhafterweise ist die Kühleinheit hierbei derart ausgebildet, dass ein partielles Kühlen der Solarzelle möglich ist, um im Bereich der Degradation eine geringere Temperatur, verglichen mit der Temperatur im Bereich der Regeneration zu erzielen.

Weitere bevorzugte Merkmale und Ausführungsformen werden im Folgenden anhand von Ausführungsbeispielen und den Figuren erläutert. Dabei zeigt:
- Figur 1: das bereits vorangehend erläuterte 3-Zustands-Modell für die Zustände degeneriert (D), regeneriert (R) und annealed (A);
- Figur 2: ein erstes Ausführungsbeispiel einer beispielhaften Vorrichtung mit einer Degradationsstrahlungsquelle und einer separaten Regenerationsstrahlungsquelle;
- Figur 3: ein zweites Ausführungsbeispiel einer beispielhaften Vorrichtung mit einer aktiv gekühlten Halterung für eine Solarzelle;
- Figur 4: eine Illustration der Beaufschlagung einer Solarzelle mit Strahlung, wobei die Intensität zu den Rändern der Solarzelle hin abnimmt;
- Figur 5: eine Illustration bei Beaufschlagung der Solarzelle mit Strahlung, wobei die Strahlung in einem streifenförmigen Bereich über die Oberfläche der Solarzelle hinwegbewegt wird und
- Figur 6: eine Weiterbildung des Ausführungsbeispiels gemäß Figur 5 mit unterschiedlichen Intensitäten zu Beginn und am Ende des Prozessierungsschrittes.

Sämtliche Figuren zeigen schematische, nicht maßstabsgetreue Darstellungen. In den Figuren bezeichnen gleiche Bezugszeichen gleiche oder gleichwirkende Elemente;
In Figur 2 ist ein erstes Beispiel einer Vorrichtung zum Stabilisieren einer photovoltaischen Silizium-Solarzelle dargestellt. Die Vorrichtung weist eine Regenerationsstrahlungsquelle 1 zum Beaufschlagen einer zu stabilisierenden Silizium-Solarzelle 2 mit Regenerationsstrahlung auf.

Weiterhin weist die Vorrichtung eine Degradationsstrahlungsquelle 3 zum Beaufschlagen der Solarzelle 2 mit Degradationsstrahlung auf sowie eine aktive Kühleinheit 4, welche vorliegend umfassend zwei Gebläse 4a und 4b ausgebildet ist.

Die Degradationsstrahlungsquelle 3 und die Gebläse 4a und 4b sind derart angeordnet und zusammenwirkend ausgebildet, dass die Solarzelle 2 in der in Figur 2 dargestellten Degradationsposition gleichzeitig mit der Degradationsstrahlung beaufschlagbar und kühlbar ist.

Die Vorrichtung gemäß Figur 2 weist weiterhin ein Förderband 5 auf, um die Solarzelle 2 in die dargestellte Degradationsposition und eine gestrichelt dargestellte Regenerationsposition zu fördern.

Weiterhin sind zusätzliche Gebläse 5a und 5b vorgesehen, so dass auch während des Regenerationsvorgangs ein aktives Kühlen der Solarzelle durch Anblasen möglich ist.

Die Vorrichtung gemäß Figur 2 ermöglicht insbesondere ein zuverlässiges und gleichzeitig verglichen mit vorbekannten Verfahren kürzeres Stabilisierungsverfahren, da in der in Figur 2 dargestellten Regenerationsposition der Silizium-Solarzelle 2 mittels der Degradationsstrahlungsquelle 3 die Solarzelle mit hoher Lichtintensität beaufschlagbar ist und gleichzeitig mittels der Gebläse 4a und 4b aufgrund der aktiven Kühlung gewährleistet wird, dass eine vorgegebene Maximaltemperatur der Silizium-Solarzelle 2 nicht überschritten wird.

Vorliegend ist die Degradationsstrahlungsquelle als eine Matrix von Diodenlasern mit 30 Lasern pro Zeilen, bei 30 Zeilen ausgebildet, welche Licht im Wellenlängenbereich 850 nm erzeugen. Ebenso kann Licht im Wellenlängenbereich 808 nm oder 980 nm verwendet werden. Ebenso können Matrizen von Diodenlasern mit einer unterschiedlichen Anzahl von Lasern pro Zeile und Anzahl von Spalten verwendet werden. Ebenso kann lediglich ein Laser verwendet werden, dessen Ausgangsstrahl mittels optischer Mittel entsprechend räumlich aufgeweitet und hinsichtlich der Intensität homogenisiert wird. An der Oberfläche der Silizium-Solarzelle wird in dem Degradationsschritt Licht mit einer Intensität von 50.000 W/m² mittels der Degradationsstrahlungsquelle 3 erzeugt. Gleichzeitig erfolgt ein Anblasen mittels der Gebläse 4a und 4b mit Umgebungsluft, so dass die Solarzelle eine Temperatur von 60 °C nicht übersteigt.

Hierdurch ist eine schnelle und zuverlässige Degradation gewährleistet. Insbesondere ist eine Regeneration aufgrund der vergleichsweise geringen Prozesstemperatur der Solarzelle ausgeschlossen oder zumindest erheblich verringert. Bei diesen Prozessparametern kann mit einer Prozesszeit kleiner 10 s eine zuverlässige Degradation durchgeführt werden.

Anschließend wird die Solarzelle mittels des Förderbandes 5 in die gestrichelt dargestellte Regenerationsposition gefördert. Dort erfolgt ein Beaufschlagen mit Strahlung der Regenerationsstrahlungsquelle 1, wobei auch hier mittels der Gebläse 5a und 5b die Solarzelle gekühlt wird durch Anblasen mit Umgehungsluft, jedoch derart, dass die Solarzelle eine Temperatur im Bereich 120 °C bis 250 °C aufweist.

Die Regenerationsstrahlungsquelle weist mehrere Halogenlampen zur Strahlungserzeugung auf.

Alternativ kann der Regenerationsprozess auch mit anderen Aufbauten, insbesondere wie aus dem eingangs zitierten Stand der Technik bekannt, durchgeführt werden. Wesentlich ist, dass für eine zuverlässige und gleichzeitig schnelle Degradation in dem Degradationsschritt die Silizium-Solarzelle 2 gleichzeitig mit Strahlung einer hohen Intensität beaufschlagt und aktiv gekühlt wird.

In einem alternativen Aufbau sind anstelle der Gebläse 4a und 4b Spritzdüsen zum Sprühen eines Kühlflüssigkeitsnebels auf die Silizium-Solarzelle 2 in Degradationsstellung angeordnet. Über einen gekühlten Kühlflüssigkeitstank wird mittels einer Pumpe Kühlflüssigkeit zu den beiden Spritzdüsen zugeführt, so dass durch Besprühen der Solarzelle die aktive Kühlung erfolgt, so dass die Solarzelle während des Degradationsschrittes eine vorgegebene Temperatur nicht überschreitet.

In einer weiteren Alternative wird ein gekühltes Gas, beispielsweise gekühlte Umgebungsluft oder andere Gasarten, wie beispielsweise gekühltes Argongas den Gebläsen 4a und 4b zugeführt, so dass eine effizientere Kühlung möglich ist. Weiterhin ist es vorteilhaft, ein besonders reines Gas und/oder gereinigte, insbesondere gefilterte, Umgebungsluft, insbesondere Argongase wie zuvor beschrieben mittels der Gebläse zur Kühlung zuzuführen, um eine Verunreinigung der Solarzelle und des Prozessraums zu vermeiden.

Weiterhin ist es vorteilhaft, die in Figur 2 dargestellten Komponenten in einem Gehäuse anzuordnen.

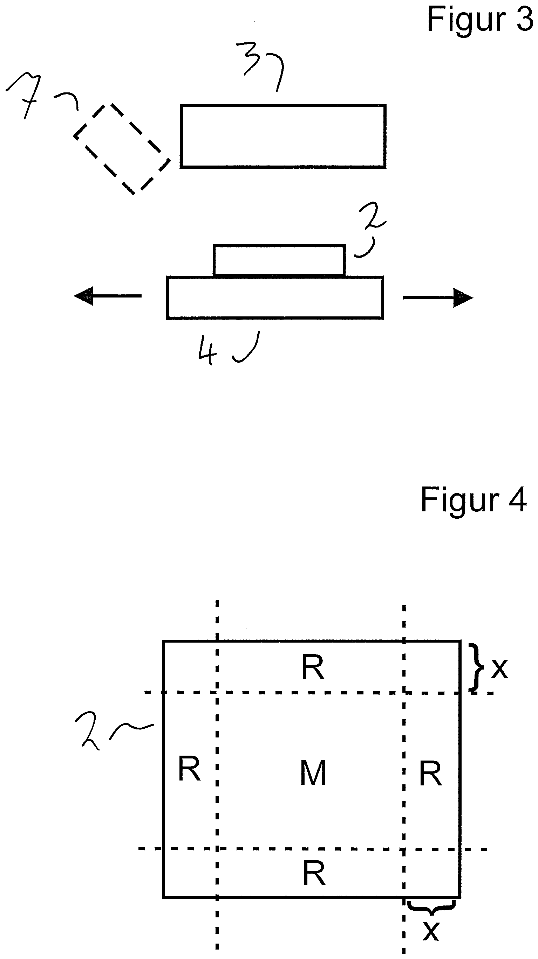

In Figur 3 ist ein zweites Ausführungsbeispiel einer beispielhaften Vorrichtung dargestellt. Zur Vermeidung von Wiederholungen wird lediglich auf die wesentlichen Unterschiede im Vergleich zu der Vorrichtung gemäß Figur 2 eingegangen:
Die Kühleinheit 4 der Vorrichtung gemäß Figur 3 ist als aktiv gekühlte Halterung, vorliegend als metallischer Block (auch als "Chuck" bezeichnet) ausgebildet. Diese Halterung weist vorzugsweise Öffnungen zum Ansaugen der Solarzelle an die Halterung in an sich bekannter Weise auf. Weiterhin weist die Halterung Kühlleitungen auf, durch welche Kühlflüssigkeit mittels einer Pumpe gepumpt wird, um die Halterung auf eine vorgegebene Temperatur zu kühlen. Insbesondere kann die Halterung 4 gemäß oder zumindest im Wesentlichen wie entsprechende Blöcke ausgebildet sein, welche zur Vermessung von Solarzellen, insbesondere zur Hellkennlinienmessung, (so genannte "Messblöcke") ausgebildet sein.

Dieses Ausführungsbeispiel weist den Vorteil auf, dass die aktive Kühleinheit 4 gegenüber der Silizium-Solarzelle 2 eine wesentlich größere thermische Masse besitzt, so dass in sehr zuverlässiger Weise die Silizium-Solarzelle 2 die Temperatur der Silizium-Solarzelle 2 der Temperatur der aktive Kühleinheit 4 entspricht.

In einer vorteilhaften Ausbildung ist die aktive Kühleinheit nach rechts und links verschiebbar, insbesondere motorisch verschiebbar, wie durch die Pfeile angedeutet. Hierdurch kann in einer Art Pendelbetrieb auf einer Seite eine Solarzelle aufgenommen werden, anschließend die Solarzelle in die dargestellte Position zur Durchführung des Prozessschrittes gebracht werden und anschließend beispielsweise an der gegenüberliegenden Seite der Solarzelle zu einer Ausgabeposition gebracht werden.

In einer vorteilhaften Weiterbildung weist die Vorrichtung gemäß Figur 3 eine gestrichelt dargestellte, optische Temperaturmess- und Regelungseinheit 7 auf. Die Temperaturmess- und Regelungseinheit ist mit der Degradationsstrahlungsquelle 3 verbunden und regelt deren Leistung derart, dass die Solarzelle im Degenerationsschritt dass die Solarzelle eine Temperatur im Bereich 50 °C bis 60 °C aufweist.

Bei der Vorrichtung gemäß Figur 3 kann durch Ändern der Kühlleistung, mit welcher die Halterung gekühlt wird und/oder durch Ändern der Strahlungsleistung, mit welcher die Degradationsstrahlungsquelle 3 die Silizium-Solarzelle 2 beaufschlagt, sowohl der Degradationsschritt, als auch nach Abschluss des Degradationsschrittes nachfolgend der Regenerationsschritt durchgeführt werden. Wesentlich ist hierbei insbesondere, dass der Degradationsschritt bei einer geringeren Temperatur der Silizium-Solarzelle durchgeführt wird, verglichen mit der Temperatur der Silizium-Solarzelle 2 bei dem Regenerationsschritt.

Ebenso ist es möglich, die Vorrichtung gemäß Figur 3 ausschließlich für den Degradationsschritt zu verwenden und anschließend in einem nicht dargestellten Bereich der Vorrichtung, welcher eine Regenerationsstrahlungsquelle umfasst, die Regeneration durchzuführen. Dies weist den Vorteil auf, dass die jeweiligen Bereiche der Vorrichtung für einerseits den Degradationsschritt und andererseits den Regenerationsschritt optimiert werden können.

Es liegt im Rahmen der Erfindung, zum Durchführen der Degradation die Silizium-Solarzelle ganzflächig mit Degradationsstrahlung zu beaufschlagen oder lediglich einen Teilbereich der Solarzelle mittels Degradationsstrahlung zu beaufschlagen, wobei vorteilhafterweise der Teilbereich über die Solarzelle verschoben wird, so dass im Ergebnis die gesamte Solarzelle mit Degradationsstrahlung beaufschlagt wurde und/oder sukzessive mehrere Teilbereiche mit Degradationsstrahlung beaufschlagt werden, so dass im Ergebnis die gesamte Solarzelle mit Degradationsstrahlung beaufschlagt wurde. Vorteilhafte Ausgestaltungen hiervon werden im Folgenden anhand der Figuren 4 bis 6 erläutert:
Figur 4 zeigt eine Draufsicht von oben auf eine Silizium-Solarzelle 2, welche ganzflächig mit Degradationsstrahlung beaufschlagt wird. Da mittlere Bereiche der Solarzelle zu allen Seiten hin mit entsprechend temperierten Bereichen der Solarzelle in Verbindung stehen, ist hier typischerweise ein höherer Energieeintrag möglich, verglichen mit Randbereichen, an welchen über den Rand nur eine geringere Wärmeableitung erfolgt. Um eine überhöhte Temperatur in den Randbereichen der Silizium-Solarzelle zu vermeiden, ist es daher vorteilhaft, die Randbereiche mit einer geringeren Intensität verglichen mit einem Mittelbereich zu beaufschlagen. In Figur 4 sind durchgestrichelte Linien die Randbereiche R an den vier Rändern der Solarzelle dargestellt, welche in einem Abstand X im Bereich von 0,5 cm bis 5 cm, insbesondere von etwa 1 cm Abstand zu dem jeweiligen Rand aufweisen. Die Degradationsstrahlungsquelle ist wie zuvor beschrieben vorteilhafterweise derart ausgebildet, dass in dem Mittelbereich M eine Beaufschlagung der Silizium-Solarzelle mit einer höheren Intensität verglichen mit der Intensität in den Randbereichen R erfolgt. Insbesondere ist die Intensität in den Randbereichen bevorzugt um etwa 5 %, insbesondere bevorzugt um etwa 10 % geringer, als in dem Mittelbereich M, wobei hier typischerweise aufgrund der Wärmeleitung ein fließender Temperaturübergang zwischen dem Mittelbereich M und den Randbereichen R gegeben ist, d. h. die Temperaturänderung nicht stufenartig verläuft.

Eine derartig angepasste Bestrahlungsintensität gemäß Figur 4 ist insbesondere vorteilhaft, wenn die Silizium-Solarzelle nicht mit einer erheblich größeren thermischen Masse verbunden ist, beispielsweise, wenn die Solarzelle wie in der Vorrichtung gemäß Figur 1 durch Anblasen gekühlt wird und insbesondere, wenn das Förderband in an sich bekannter Weise wie beispielsweise bei Durchlauföfen lediglich aus zwei vergleichsweise dünnen Bändern oder Schnüren besteht, die somit nur eine geringe thermische Masse und wenig Wärmeableitung aufweisen.

Bei einer Ausgestaltung der Kühleinheit gemäß Figur 2, d. h. bei Verwendung eines Kühlblocks mit integrierter aktiver Kühlung oder mit aktiver Kühlung durch Zuführen einer Kühlflüssigkeit ist typischerweise eine um ein vielfaches höhere thermische Masse der als Kühlblock ausgebildeten Halterung gegenüber der Silizium-Solarzelle gegeben, so dass in diesem Fall, auch wegen eines sehr guten thermischen Kontakts aufgrund des Aufliegens der Rückseite der Solarzelle auf der Halterung, insbesondere einem im wesentlichen ganzflächigen Aufliegen, eine inhomogene Temperaturverteilung der Solarzelle während des Degradationsvorgangs nicht vorhanden oder zumindest in einem wesentlich geringeren Umfang vorhanden. Hier kann somit eine ganzflächige, homogene Bestrahlung verwendet werden. Hierdurch wird eine konstruktiv einfache Ausgestaltung erzielt. Zur Erhöhung der Temperaturhomogenität kann selbstverständlich auch in diesem Fall eine örtlich inhomogene Bestrahlungsintensität, insbesondere gemäß Figur 4, verwendet werden.

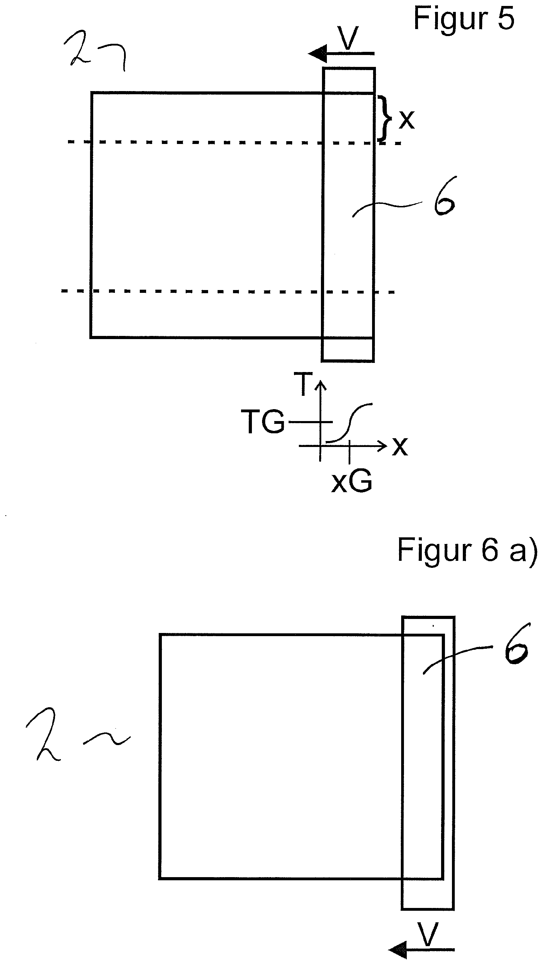

In einem alternativen Ausführungsbeispiel zu der ganzflächigen Bestrahlung, insbesondere einer ganzflächigen Bestrahlung gemäß Figur 4 während des Degradationsvorgangs wird in Figur 5 dargestellt lediglich ein streifenartiger Degradationsbereich 6 der Silizium-Solarzelle mit Degradationsstrahlung beaufschlagt, wobei der Degradationsbereich 6 gemäß der Richtung V relativ zu der Silizium-Solarzelle 2 bewegt wird, so dass im Ergebnis die gesamte Oberfläche der Silizium-Solarzelle 2 mit Degradationsstrahlung beaufschlagt wurde. Hierdurch kann in vorteilhafter Weise ein Durchlaufverfahren realisiert werden, insbesondere dadurch, dass bei einem örtlich feststehenden Degradationsbereich 6 die Solarzelle entgegengesetzt zu der Richtung V in Figur 5 bewegt wird.

Zur Optimierung der jeweiligen Prozessbedingungen wird zunächst der Degradationsschritt durchgeführt. In einem anschließenden, separaten Verfahrensschritt wird die Regeneration durchgeführt. Diese kann eine ganzflächige Beaufschlagung mit Regenerationsstrahlung umfassen oder ebenso lediglich die Beaufschlagung eines Teilbereiches der Solarzelle mit Regenerationsstrahlung, wobei der Teilbereich relativ zu der Solarzelle bewegt wird, so dass im Ergebnis die gesamte Solarzelle mit Regenerationsstrahlung beaufschlagt wurde.

Dies weist den Vorteil auf, dass jeweils optimale Prozessbedingungen für Degradation einerseits und Regeneration andererseits in besonders zuverlässiger Weise vorgegeben werden können.

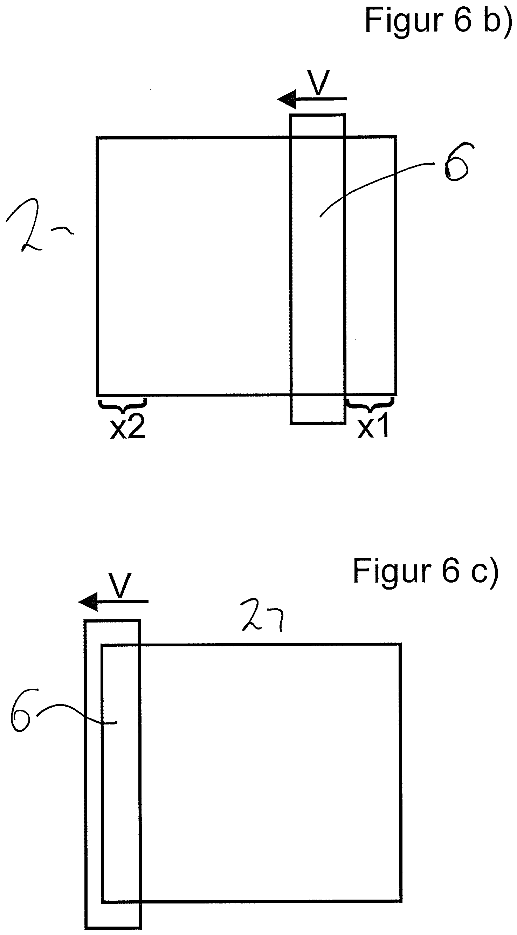

Eine konstruktiv vorteilhaft einfache Ausgestaltung ergibt sich, indem in einer alternativen Ausgestaltung die Bestrahlung des in Figur 5 dargestellten Teilbereiches in einem ersten in Figur 6 links liegenden Teilbereich zur Degradation und in einem zweiten, rechts liegendem Teilbereich zur Regeneration verwendet wird:
Hierbei wird der Umstand ausgenutzt, dass sich die Solarzelle bei Relativverschiebung des Bereiches gemäß der Richtung V zu der Silizium-Solarzelle von einer Ausgangstemperatur ausgehend durch die Beaufschlagung mit Strahlung erwärmt. Es können somit Prozessparameter gewählt werden, so dass sich innerhalb des Bereiches 6 in Figur 5 ein Temperaturverlauf wie schematisch unterhalb der Figur 5 dargestellt ergibt:
In dieser schematischen, qualitativen Darstellung ist der Ort x gegenüber der Temperatur T der Solarzelle aufgetragen. Da der Bereich 6 bei der Darstellung gemäß Figur 5 von rechts nach links verschoben wird und in diesem Ausführungsbeispiel die Solarzelle zu Beginn eine niedrige Temperatur (beispielsweise etwa Raumtemperatur, insbesondere etwa 20 °C) aufweist, erfolgt eine Erwärmung der Solarzelle aufgrund der Beaufschlagung mit Strahlung. Die Parameter sind nun derart gewählt, dass in einem Grenzbereich X_{G} eine Grenztemperatur T_{G} überschritten wird, so dass unterhalb dieser Grenztemperatur im Wesentlichen eine Degeneration und oberhalb dieser Grenztemperatur im Wesentlichen bzw. zunehmend eine Regeneration stattfindet. Hierdurch kann ebenfalls Degradation und Regeneration in zwei aufeinander folgenden, separaten Prozessschritten durchgeführt, wobei die Grenze Xg zwischen Degeneration und Regeneration mit Verschieben des Teilbereiches relativ zu der Silizium-Solarzelle ebenfalls verschoben wird, so dass nach vollständigem Verschieben des Teilbereiches über die gesamte Solarzelle eine vollständige regenerierte Solarzelle resultiert. Diese Variante ermöglicht eine konstruktiv einfache Ausgestaltung, da insbesondere die Verwendung lediglich einer Strahlungsquelle notwendig ist und darüber hinaus ein räumlich kompakter Aufbau gewährleistet ist. Im Gegenzug ist jedoch eine genaue Justierung und Einhaltung der Prozessparameter notwendig. In einer vorteilhaften Weiterbildung wird die Solarzelle in dem gemäß Figur 5 links der Grenze X_{G} liegenden Bereich gekühlt, insbesondere mit einem Kühlgas angeblasen, um den Temperaturunterschied im Degenerationsbereich 6 zu bewirken.

Bei Verfahrensvarianten, bei welchen separat zunächst die Solarzelle vollständig degradiert und anschließend die Solarzelle vollständig regeneriert wird, ist typischerweise eine größere Robustheit und Fehlerunanfälligkeit gegenüber Schwankungen in den Prozessparametern gewährleistet.

In Figur 6 ist ein Ausführungsbeispiel des Degradationsschrittes dargestellt, bei welchem wie auch zu Figur 5 beschrieben ein Degradationsbereich 6, in welchem die Solarzelle mit Degradationsstrahlung beaufschlagt wird, gemäß einer Richtung V relativ zu der Silizium-Solarzelle bewegt wird, so dass im Ergebnis die gesamte Oberfläche der Silizium-Solarzelle mit Degradationsstrahlung beaufschlagt wird. Auch hier wird zur Berücksichtigung des abweichenden thermischen Verhaltens der Randbereiche der Solarzelle zunächst in dem in Teilbild a) dargestellten Zustand, in welchem der Degradationsbereich einen ersten, rechtsliegenden Rand der Solarzelle 2 überdeckt, die Solarzelle mit feiner in diesem Anfangsbereich erhöhten Anfangsintensität mit Degradationsstrahlung beaufschlagt. Hierdurch wird kompensiert, dass in diesem Anfangsbereich die verbleibende Solarzelle typischerweise noch eine geringere Temperatur aufweist und daher mit einer höheren Intensität beaufschlagt werden kann, um in einen gewünschten Temperaturbereich zu gelangen.

In einem mittigen Bereich, nachdem der Degradationsbereich einen Abstand X₁, insbesondere einen Abstand von etwa 1 cm zu dem rechts liegenden Rand und somit Anfangsbereich aufweist, wird die Solarzelle mit einer gegenüber der Anfangsintensität kleineren Mittelintensität mit Degradationsstrahlung beaufschlagt. Dies ist in Teilbild b) dargestellt.

Am Ende des Degradationsschrittes, wie in Teilbild c) dargestellt, wenn der Degradationsbereich 6 den gegenüberliegenden, in Figur 6 links liegenden Rand der Solarzelle überdeckt, wird die Solarzelle mit einer gegenüber der Anfangsintensität und gegenüber der Mittelintensität geringeren Endintensität mit Degradationsstrahlung beaufschlagt.

Hierdurch kann eine besonders hohe Konsistenz der Temperatur der Solarzelle erzielt werden. Ein derartiges Verfahren ist ebenso im Regenerationsschritt anwendbar. Da typischerweise die Temperatursensitivität im Regenerationsschritt höher ist als im Degradationsschritt, ist es insbesondere vorteilhaft, die Ausgestaltung wie zuvor beschrieben in dem Regenerationsschritt anzuwenden.

## Patentansprüche

1. Verfahren zum Stabilisieren einer photovoltaischen Silizium-Solarzelle (2), mit einem Regenerationsschritt, wobei ein Injizieren von Ladungsträgern in einem Halbleitersubstrat der auf zumindest 50°C erwärmten Solarzelle erfolgt,
**dadurch gekennzeichnet,**
**dass** vor dem Regenerationsschritt ein Degradationsschritt erfolgt, wobei die Solarzelle mittels Strahlung, insbesondere Laserstrahlung, mit einer Strahlungsintensität von zumindest 5.000 W/m² beaufschlagt und gleichzeitig die Solarzelle aktiv gekühlt wird.

2. Verfahren nach Anspruch 1,
**dadurch gekennzeichnet,**
**dass** in dem Degradationsschritt die Solarzelle mittels Strahlung, insbesondere Laserstrahlung, mit einer Bestrahlungsintensität von zumindest 10.000 W/m², insbesondere zumindest 50.000 W/m², bevorzugt zumindest 100.000 W/m², insbesondere bevorzugt zumindest 500.000 W/m² beaufschlagt und gleichzeitig die Solarzelle aktiv gekühlt wird
und/oder
**dass** in dem Degradationsschritt die Solarzelle auf eine Temperatur kleiner 100°C, insbesondere kleiner 70°C, bevorzugt kleiner 50°C, insbesondere bevorzugt kleiner 40°C gekühlt wird.

3. Verfahren nach einem der vorangegangenen Ansprüche,
**dadurch gekennzeichnet,**
**dass** der Degradationsschritt für eine Zeitdauer im Bereich 0,1 s bis 10 s, vorzugsweise im Bereich 0,1 s bis 5 s durchgeführt wird.

4. Verfahren nach einem der vorangegangenen Ansprüche,
**dadurch gekennzeichnet,**
**dass** in dem Regenerationsschritt gleichzeitig zu dem Injizieren von Ladungsträgern Solarzelle ein aktives Kühlen der Solarzelle erfolgt.

5. Verfahren nach Anspruch 4,
**dadurch gekennzeichnet,**
**dass** in dem Regenerationsschritt die Solarzelle auf eine Temperatur im Bereich 90°C bis 500°C gekühlt wird und/oder
**dass** der Regenerationsschritt für eine Regenerationsdauer T kleiner 3 s, vorzugsweise kleiner 0,5 s durchgeführt wird.

6. Verfahren nach einem der vorangegangenen Ansprüche,
**dadurch gekennzeichnet,**
**dass** die Temperatur der Solarzelle gemessen wird, vorzugsweise mittels einer optischen Temperaturmessung, und
**dass** die Bestrahlungsintensität und/oder eine aktive Kühlung derart gewählt wird, dass die Temperatur der Solarzelle in eine vorgegebene Maximaltemperatur nicht übersteigt, insbesondere in einem vorgegebenen Temperaturbereich liegt.

7. Verfahren nach einem der vorangegangenen Ansprüche,
**dadurch gekennzeichnet,**
**dass** in dem Degradationsschritt Bestrahlung der Solarzelle in einem Degradationsbereich (6) erfolgt, wobei der Degradationsbereich (6) nur einen Teilbereich einer Oberfläche der Solarzelle überdeckt, vorzugsweise, wobei sich der Degradationsbereich (6) über die gesamte Breite der Solarzelle erstreckt.

8. Verfahren nach einem der vorangegangenen Ansprüche,
**dadurch gekennzeichnet,**
**dass** das Degradationsbereich (6) relativ zu der Solarzelle bewegt wird und/oder dass die Solarzelle sukzessive in mehreren, ortsverschiedenen Degradationsbereichen bestrahlt wird,
insbesondere,
**dass** in einem Anfangsbereich, in welchem der Degradationsbereich (6) einen ersten Rand der Solarzelle überdeckt, die Bestrahlung mit einer Anfangsintensität erfolgt und dass in einem Endbereich, in welchem der Degradationsbereich (6) nach der Bestrahlung des Anfangsbereiches einen zweiten Rand, insbesondere einen dem ersten Rand gegenüberliegenden Rand der Solarzelle überdeckt, die Bestrahlung mit einer gegenüber der Anfangsintensität geringeren Endintensität erfolgt,
wobei bevorzugt in einem Mittelbereich, in welchem der Degradationsbereich (6) nach der Bestrahlung des Anfangsbereiches und vor der Bestrahlung des Endbereiches einen Mittelbereich der Solarzelle überdeckt, eine Bestrahlung mit einer Mittelintensität erfolgt, welche kleiner als die Anfangsintensität und größer als die Endintensität ist.

9. Verfahren nach einem der vorangegangenen Ansprüche,
**dadurch gekennzeichnet,**
**dass** in dem Degradationsschritt die Bestrahlung in einem Degradationsbereich (6) erfolgt, welcher sich zumindest über eine Breite der Solarzelle erstreckt, wobei an den Rändern der Solarzelle die Bestrahlung mit einer geringeren Randintensität erfolgt, gegenüber einer Mittelbereichintensität, mit welcher von den Rändern beabstandete Bereiche bestrahlt werden.

10. Verfahren nach einem der vorangegangenen Ansprüche,
**dadurch gekennzeichnet,**
**dass** während des Regenerationsschritts eine aktive Kühlung der Solarzelle auf eine Teperatur kleiner 250°C erfolgt und die Solarzelle mit einer Strahlungsintensität von zumindest 10.000 W/m² beaufschlagt wird, insbesondere, dass die Gesamtprozessdauer von Degradationsschritt und Regenerationssschritt weniger als 50 s beträgt
und/oder
**dass** während des Regenerationsschritts eine aktive Kühlung der Solarzelle auf eine Teperatur im Bereich 250°C bis 400°C erfolgt und die Solarzelle mit einer Strahlungsintensität von zumindest 10.000 W/m², vorzugsweise zumindest 50.000 W/m², insbesondere zumindest 70.000 W/m² beaufschlagt wird, wobei bevorzugt die Gesamtprozessdauer von Degradationsschritt und Regenerationssschritt weniger als 50 s beträgt.

## Claims

1. Method for stabilising a photovoltaic silicon solar cell (2), having a regeneration step, wherein charge carriers are injected in a semiconductor substrate of the solar cell, which is heated to at least 50°C,
**characterised in that**
prior to the regeneration step, a degradation step is carried out, wherein the solar cell is acted upon by means of radiation, especially laser radiation, with a radiation intensity of at least 5000 W/m² and at the same time the solar cell is actively cooled.

2. Method according to claim 1,
**characterised in that**
in the degradation step, the solar cell is acted upon by means of radiation, especially laser radiation, with a radiation intensity of at least 10,000 W/m², especially at least 50,000 W/m², preferably at least 100,000 W/m², especially preferably at least 500,000 W/m², and at the same time the solar cell is actively cooled;
and/or
in the degradation step, the solar cell is cooled to a temperature of less than 100°C, especially less than 70°C, preferably less than 50°C, especially preferably less than 40°C.

3. Method according to either one of the preceding claims,
**characterised in that**
the degradation step is carried out for a period in the range from 0.1 s to 10 s, preferably in the range from 0.1 s to 5 s.

4. Method according to any one of the preceding claims,
**characterised in that**
in the regeneration step, the solar cell is actively cooled at the same time as the injection of charge carriers in the solar cell.

5. Method according to claim 4,
**characterised in that**
in the regeneration step, the solar cell is cooled to a temperature in the range of 90°C to 500°C; and/or
the regeneration step is carried out for a regeneration period T of less than 3 s, preferably less than 0.5 s.

6. Method according to any one of the preceding claims,
**characterised in that**
the temperature of the solar cell is measured, preferably by means of optical temperature measurement; and
the irradiation intensity and/or active cooling are chosen in such a way that the temperature of the solar cell does not exceed a predefined maximum temperature and especially lies in a predefined temperature range.

7. Method according to any one of the preceding claims,
**characterised in that**
in the degradation step, irradiation of the solar cell is carried out in a degradation region (6), wherein the degradation region (6) covers only a sub-region of a surface of the solar cell, preferably wherein the degradation region (6) extends over the entire width of the solar cell.

8. Method according to any one of the preceding claims,
**characterised in that**
the degradation region (6) is moved relative to the solar cell; and/or the solar cell is irradiated successively in a plurality of differently located degradation regions;
especially,
in an initial region, in which the degradation region (6) covers a first margin of the solar cell, the irradiation is carried out with an initial intensity; and in an end region, in which the degradation region (6), after the irradiation of the initial region, covers a second margin of the solar cell, especially a margin that is located opposite the first margin, the irradiation is carried out with an end intensity that is lower than the initial intensity,
wherein preferably in a central region, in which the degradation region (6), after the irradiation of the initial region and before the irradiation of the end region, covers a central region of the solar cell, irradiation is carried out with a medium intensity which is lower than the initial intensity and greater than the end intensity.

9. Method according to any one of the preceding claims,
**characterised in that**
in the degradation step, the irradiation is carried out in a degradation region (6) which extends at least over a width of the solar cell, wherein at the margins of the solar cell the irradiation is carried out with a lower margin intensity compared with a central region intensity with which regions that are spaced apart from the margins are irradiated.

10. Method according to any one of the preceding claims,
**characterised in that**
during the regeneration step, the solar cell is actively cooled to a temperature of less than 250°C and the solar cell is acted upon with a radiation intensity of at least 10,000 W/m²; especially, the total process duration of degradation step and regeneration step is less than 50 s;
and/or
during the regeneration step, the solar cell is actively cooled to a temperature in the range of 250°C to 400°C and the solar cell is acted upon with a radiation intensity of at least 10,000 W/m², preferably at least 50,000 W/m², especially at least 70,000 W/m², the total process duration of degradation step and regeneration step preferably being less than 50 s.

## Revendications

1. Procédé de stabilisation d'une cellule solaire photovoltaïque au silicium (2), avec une phase de régénération, dans lequel une injection de porteurs de charge se produit dans un substrat semi-conducteur d'une cellule solaire chauffée à au moins 50 °C,
**caractérisé en ce**
**qu'**une phase de dégradation se produit avant la phase de régénération, dans lequel la cellule solaire est exposée au moyen d'un rayonnement, en particulier d'un rayonnement laser, à une intensité d'irradiation d'au moins 5000 W/m² et la cellule solaire est refroidie activement en même temps.

2. Procédé selon la revendication 1,
**caractérisé en ce**
**qu'**en phase de dégradation, la cellule solaire est exposée, au moyen d'un rayonnement, en particulier d'un rayonnement laser, à une intensité d'irradiation d'au moins 10 000 W/m², en particulier d'au moins 50 000 W/m², de préférence au moins 100 000 W/m², en particulier de préférence au moins 500 000 W/m², et la cellule solaire est refroidie activement en même temps
et/ou
**qu'**en phase de dégradation, la cellule solaire est refroidie à une température inférieure à 100 °C, en particulier inférieure à 70 °C, de préférence inférieure à 50 °C, en particulier de préférence inférieure à 40 °C.

3. Procédé selon l'une des revendications précédentes,
**caractérisé en ce**
**que** la phase de dégradation est menée sur une durée dans la plage de 0,1 s à 10 s, préférentiellement dans la plage de 0,1 s à 5 s.

4. Procédé selon l'une des revendications précédentes,
**caractérisé en ce**
**qu'**en phase de régénération, un refroidissement actif de la cellule solaire se produit en même temps que l'injection de porteurs de charge.

5. Procédé selon la revendication 4,
**caractérisé en ce**
**qu'**en phase de régénération, la cellule solaire est refroidie à une température dans la plage de 90 °C à 500 °C et/ou
**que** la phase de régénération est menée pour une durée de régénération T inférieure à 3 s, préférentiellement inférieure à 0,5 s.

6. Procédé selon l'une des revendications précédentes,
**caractérisé en ce**
**que** la température de la cellule solaire est mesurée, préférentiellement à l'aide d'une mesure de température optique, et
**que** l'intensité d'irradiation et/ou un refroidissement actif sont choisis de telle manière que la température de la cellule solaire ne dépasse pas une température maximale indiquée, en particulier se situe dans une plage de température indiquée.

7. Procédé selon l'une des revendications précédentes,
**caractérisé en ce**
**qu'**en phase de dégradation, une irradiation de la cellule solaire se produit dans une zone de dégradation (6), dans lequel la zone de dégradation (6) ne couvre qu'une partie d'une surface de la cellule solaire, préférentiellement, dans lequel la zone de dégradation (6) s'étend sur toute la largeur de la cellule solaire.

8. Procédé selon l'une des revendications précédentes,
**caractérisé en ce**
**que** la zone de dégradation (6) est déplacée par rapport à la cellule solaire et/ou que la cellule solaire est irradiée progressivement dans plusieurs zones de dégradation à des endroits différents,
en particulier,
**que** dans une zone initiale, dans laquelle la zone de dégradation (6) couvre une première bordure de la cellule solaire, l'irradiation se produit avec une intensité initiale et que dans une zone terminale, dans laquelle la zone de dégradation (6) couvre une deuxième bordure après l'irradiation de la zone initiale, en particulier l'une des bordures en face de la première bordure de la cellule solaire, l'irradiation se produit avec une intensité terminale inférieure à l'intensité initiale,
dans lequel préférentiellement dans une zone centrale, dans laquelle la zone de dégradation (6) couvre une zone centrale de la cellule solaire après l'irradiation de la zone initiale et avant l'irradiation de la zone terminale, une irradiation se produit avec une intensité moyenne, qui est inférieure à l'intensité initiale et supérieure à l'intensité terminale.

9. Procédé selon l'une des revendications précédentes,
**caractérisé en ce**
**qu'**en phase de dégradation, l'irradiation se produit dans une zone de dégradation (6) qui s'étend au moins sur une largeur de la cellule solaire, dans lequel l'irradiation se produit aux bordures de la cellule solaire avec une intensité de bordure inférieure, à une intensité de zone centrale, avec laquelle les zones espacées des bordures sont irradiées.

10. Procédé selon l'une des revendications précédentes,
**caractérisé en ce**
**qu'**en phase de régénération, un refroidissement actif de la cellule solaire se produit à une température inférieure à 250 °C, et la cellule solaire est exposée à une intensité d'irradiation d'au moins 10 000 W/m², en particulier que toute la durée de processus de la phase de dégradation et de la phase de régénération est inférieure à 50 s
et/ou
**qu'**en phase de régénération, un refroidissement actif de la cellule solaire se produit à une température dans la plage de 250 °C à 400 °C, et la cellule solaire est exposée à une intensité d'irradiation d'au moins 10 000 W/m², de préférence au moins 50 000 W/m², en particulier d'au moins 70 000 W/m², dans lequel préférentiellement toute la durée du processus de la phase de dégradation et de la phase de régénération est inférieure à 50 s.
